(19) **Europäisches Patentamt**

**European Patent Office**

**Office européen des brevets**

(11) **EP 0 806 734 B1**

(12) **EUROPEAN PATENT SPECIFICATION**

(45) Date of publication and mention
of the grant of the patent:
**26.03.2003 Bulletin 2003/13**

(51) Int Cl.⁷: **G06F 17/50**

(21) Application number: **96107106.5**

(22) Date of filing: **06.05.1996**

(54) **Method for modelling a process flow according to time constraints on a computer**

Verfahren zur Modellierung eines Prozessablaufs nach Zeitzwangsbedingungen

Méthode pour modeler un déroulement de processus selon des contraintes de temps

(84) Designated Contracting States:
**AT CH DE FR GB IT LI**

(43) Date of publication of application:
**12.11.1997 Bulletin 1997/46**

(73) Proprietor: **SIEMENS AKTIENGESELLSCHAFT**
**80333 München (DE)**

(72) Inventor: **Brandin, Bertil, Dr.**
**80469 München (DE)**

(56) References cited:
**EP-A- 0 445 942**       **EP-A- 0 577 298**

- **IEEE TRANSACTIONS ON AUTOMATIC CONTROL, vol. 39, no. 2, February 1994, NEW YORK US, pages 329-342, XP000605069 BRANDIN ET AL: "supervisory control of timed discrete-event systems"**
- **IEEE/ACM INTERNATIONAL CONFERENCE ON COMPUTER-AIDED DESIGN, 6 November 1994, SAN JOSE CA USA, pages 450-457, XP000529857 BALARIN ET AL: "iterative algorithms for formal verification of embedded real-time systems"**

**Description**

Advances in automated manufacturing and trends towards the application of more computer implemented process controls, as well as the increase of the size of such implementations lead to even more complex and clumsy process-control-structures. In application fields such as automated production, complex layered communication-protocols, like in ISDN, or Video on demand, computer communication, internal processor busses, transportation systems, or object communication in object oriented programs, time requirements get more and more important and, caused by the complexity of the problems, urge the need for a suitable method of description or modelling of such process-flows.

Several approaches have been made to this subject. The most recent known one state of the art is described in B. A. Brandin, W. M. Wonham, "The supervisory control of timed discrete-event systems", IEEE Transactions on Automatic Control, February 1994, pp. 329-342. There a modelling method is shown using timed state based processes, automatons, as modelling parts of processes to be modelled. Time units called "ticks" are used to show the inter dependencies of the automatons. It can be easily conceived from this document, that although establishing time constraints like upper- and lower time-bounds, while using ticks and automatons for modelling, even small automatons with few possible activities and few state transitions lead to fairly complex activity transition graphs. In order to establish a model of a more complex process-flow, these activity transition graphs have to be composed in one global process model, which ends up in a very large ununderstandable control-structure as shown for example in Figure 20.

Thus it is an object of the invention to provide a Method for modelling a process flow according to time constraints on a computer, which leads to smaller and more user transparent Process-models. A further object of the invention is to omit "ticks" as time units. A further object of the invention is to provide a modelling method which is easily adaptable to process-control of technical processes.

These objects are solved according to the invention claimed in claim one.

Preferable embodiments of the inventions are claimed in the dependant claims.

The invention has the advantage, that it delivers automatically computer generated complete models of complex process flows, which are compact and can be adapted to be used for further implementation of process control strategies.

The invention has the further advantage, that it provides a new treatment of time constraints, which enables the modelling method to deal with activities instead of dealing with "ticks" and thus provides an inproved amount of compaction as compared to the state of the art.

The invention has the further advantage, that it can be easily used to model process flows in any of the above mentioned technical fields and other similar fields known to a person skilled in the art.

The invention has the further advantage, that it provides a suitable way for the modelling method to be implemented as a very efficient computer executable process .

The invention has the further advantage, that it delivers the computer generated data in such fashion, that they can be automatically converted into activity transition graphs.

The invention has the further advantage, that it enables automated coding of process-controls.

The invention has the further advantage, that it reduces the necessary amount of work to establish a process controller.

The invention has the advantage, that for the first time it enables the modelling and analysis of very complex processes.

In the following part of the description the invention is further disclosed using equations and figures.

Figure 1     illustrates the relation between $\Sigma$, $\Sigma_u$, $\Sigma_c$ and $\Sigma_f$;

Figure 2     illustrates two vehicles $V_1$ and $V_2$;

Figure 3     illustrates the timed behavior of the two vehicles traveling concurrently;

Figure 4     illustrates a manufacturing cell; and

Figure 5     illustrates the timed behavior of two machines working concurrently.

**1 Notation**

Let $A$ and $B$ be arbitrary sets. Let $a$ be an element of $A$. $a \in A$ denotes a is in $A$. $A \times B$ denotes the Cartesian product of $A$ and $B$. $|A|$ denotes the cardinality of $A$, i.e. the number of objects in $A$. Let $A$ be an arbitrary set of indexed objects $a_i$, $i \in I$, with $I$ denoting the corresponding index set. $\Pi_{i \in I} a_i$ denotes the Cartesian product of the objects $a_i \in A$ over the index set $I$. Let $A$ and $B$ be two arbitrary subsets of a set $C$ of objects. $A \subseteq C$ denotes set inclusion, and $A$

$\subset$ *C* denotes strict set inclusion. $A \cup B$ denotes set union, and $A \dot\cup B$ denotes the union of disjoint sets. Let $A_i$, $i \in I$ be arbitrary indexed subsets of a set *C* of objects, with *I* denoting the corresponding index set. $\cup_{i \in I} A_i$ denotes the set union of the subsets $A_i$ over the index set *I*. $A \cap B$ denotes set intersection.

Let $\infty$ denote infinity. Let *N* denote the natural numbers $\{0, 1, 2,...\}$. For $a$, $b \in$ N$\dot\cup \{\infty\}$ and $a$ and $b$ not simultaneously $\infty$, define $a \dot- b = \max(0, a - b)$.

Let $\vee$ denote the logical disjunction operator (or), $\wedge$ denote the logical disjunction operator (and), $\neg$ denote the logical negation operator (not), $\forall x$ denote the universal quantifier, $\exists x$ denote the existential quantifier.

An *automaton* (or *finite state machine)* G is given by G = $(\Sigma, Q, \delta, q_0, Q_m)$ in which $\Sigma$ is an *alphabet,* Q = $\{q_0, q_1, ...\}$ is the *state set* (assumed finite and nonempty), $\delta : Q \times \Sigma \to Q$ is the *transition function*, $q_0 \in Q$ is the initial state and $Q_m \subseteq Q$ is the *marked state set.* Let the transition function $\delta : Q \times \Sigma \to Q$ be defined at each $q \in Q$ only for a subset of the elements $\sigma \in \Sigma$; namely $\delta$ is a partial function. The notation $\delta(\sigma, q)!$ will mean that $\delta(\sigma,q)$ is defined. The *events* in a state based process modeled by the automaton G constitute the alphabet $\Sigma$, and are state transitions from a state $q_i \in Q$ to a state $q_j \in Q$ for which $\delta$ is defined.

Let G = $(\Sigma, Q, \delta, q_0, Q_m)$ be an automaton. In order to represent G, *Q* may be identified with the nodes of a directed graph *G* whose edges are labeled with symbols $\sigma \in \Sigma$; namely $(q, \sigma, q')$ is a labeled edge

$$q \circ \xrightarrow{\ \sigma\ } \circ q'$$

of *G*, if and only if $\delta(\sigma, q) = q'$. Such a graph is a *state transition graph* for **G**. In *G* we attach to $q_0$ an entering arrow as in $\to \circ q_0$, and marker states $q \in Q_m$ are represented as in $q\bullet$.

## 2 Modelling

In order to model the timed behavior a timed state based process we start with

(i) an automaton (or finite state machine) A = $(\Sigma, A, \delta_A, a_o, A_m)$ representing the untimed behavior of the state based process. $\Sigma$ is a finite alphabet of event labels (or simply events). *A* represents an activity set whose elements are activities *a*. Here we shall restrict *A* to be finite. In the interpretation of A considered here, activities have duration in time, while events are instantaneous. The activity transition function $\delta_A$ is a partial function $\delta_A : A \times \Sigma \to A$. $a_o$ is the initial activity and $A_m \subseteq A$ is the subset of marker activities. These are activities which have a particular meaning from a control perspective, such as for example, the end of a machine work cycle.

(ii) together with *default lower* and *upper time bounds* for the events $\sigma \in \Sigma$. Let N denote the natural numbers $\{0, 1, 2, ...,\}$. Each event label $\sigma \in \Sigma$ will be equipped with a default lower time bound $l_\sigma \in$ N, and a default upper time bound $u_\sigma \in$ N$\dot\cup\{\infty\}$, with $l_\sigma \leq u_\sigma$.

From the automaton A above and the corresponding default lower and upper time bounds, we model the timed behavior of the timed state based process considered with the automaton E = $(\Sigma, E, \delta_E, e_o, E_m)$. $\Sigma$ is the finite alphabet of event labels in A above. *E* represents the timed activity set whose elements are *timed activities e.* As for *A* above, *E* is restricted to be finite. The activity transition function $\delta_E$ is a partial function $\delta_E : E \times \Sigma \to E$. $e_o$ is the initial timed activity and $E_m \subseteq E$ is the subset of marker timed activities. As for $A_m$ above, these are timed activities which have a particular meaning from a control perspective.

The automaton E = $(\Sigma, E, \delta_E, e_o, E_m)$ is now defined.

For $j$, $k \in$ N write $[j, k]$ for the set of integers $i$ with $j \leq i \leq k$ and let for $\sigma \in \Sigma$

$$T_\sigma \ = \ \begin{cases} [0, u_\sigma] & \text{if} \quad u_\sigma \neq \infty \\ \{\infty\} & \text{if} \quad u_\sigma = \infty \end{cases}$$

$$R_\sigma = [0, l_\sigma].$$

The *timed activity set E* is given by $E = A \times \Pi_{\sigma \in \Sigma}(R_\sigma \times T_\sigma)$. Therefore, a timed activity is an element of the form

$$e = (a, \{(r_\sigma, t_\sigma) \text{ such that } \sigma \in \Sigma\})$$

where $a \in A$, $r_\sigma \in R_\sigma$ and $t_\sigma \in T_\sigma$; namely, $e$ consists of an activity together with $n$ integer pairs, where $n$ is the number of events $\sigma$ in $\Sigma$. $r_\sigma$ will be called the *lower-bound timer* of $\sigma$ in the timed activity $e$, and similarly $t_\sigma$ will be called the *upper-bound timer* of $\sigma$ in the timed activity $e$. $r_\sigma$ represents the delay to the earliest possible occurrence of $\sigma$ from the activity $a$. $t_\sigma$ represents the delay to the latest possible occurrence of $\sigma$ from the activity $a$ (possibly infinity). The initial timed activity is given by

$$e_o = (a_o, \{(l_\sigma, u_\sigma) \text{ such that } \sigma \in \Sigma\}).$$

The marker timed activity subset will be taken to be of the form

$$E_m \subseteq A_m \times \prod_{\sigma \in \Sigma} (R_\sigma \times T_\sigma).$$

We now provide the formal definition of $\delta_E$. Write $\delta_E(e,\sigma) = e'$, with

$$e = (a, \{(r_\tau, t_\tau \text{ such that } \tau \in \Sigma\}),$$

$$e' = (a', \{(r'_\tau, t'_\tau) \text{ such that } \tau \in \Sigma\}).$$

$\delta_E$ is defined for $\sigma \in \Sigma$ at $e$ if and only if $\sigma$ is defined from $a$ and there does not exist an other event $\alpha \in \Sigma$ defined from $a$ whose upper time bound is strictly smaller than the lower time bound of $\sigma$:

$$\delta_E(e,\sigma)! \text{ if and only if } \delta_A(a,\sigma)! \text{ and } (\neg \exists \alpha \in \Sigma_A)(\alpha \neq \sigma \wedge \delta_A(a,\alpha)! \wedge t_\alpha < r_\sigma).$$

The activity $e' = (a', \{(r'_\tau, t'_\tau) \text{ such that } \tau \in \Sigma\})$ is then defined as follows: $a' = \delta_A(a, \sigma)$ and

(i) if $\tau \neq \sigma$

$$(r'_\tau, t'_\tau) = \begin{cases} (r_\tau \dot{-} t_\sigma, t_\tau \dot{-} r_\sigma) & \text{if } \delta_A(a, \tau)! \wedge \delta_A(a', \tau)! \\ (l_\tau, u_\tau) & \text{otherwise} \end{cases}$$

(ii) if $\tau = \sigma$

$$(r'_\tau, t'_\tau) = (l_\tau, u_\tau).$$

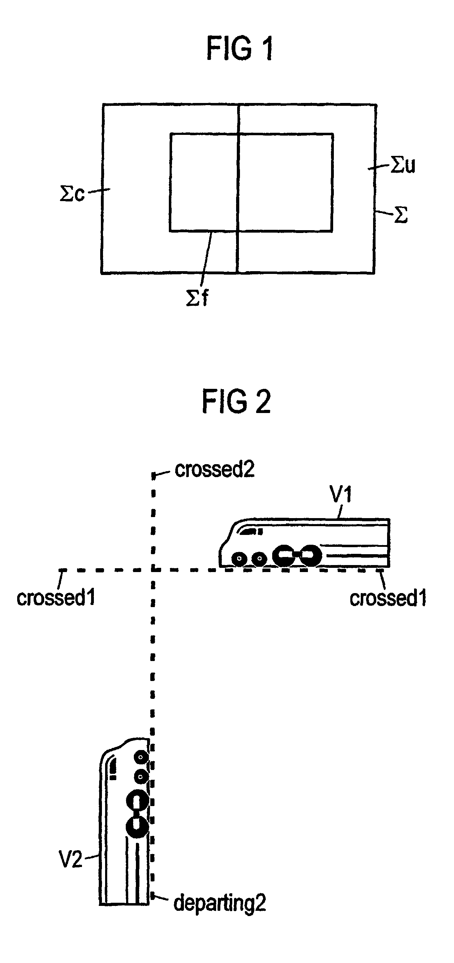

The events $\sigma \in \Sigma$ are divided in uncontrollable, controllable and forcible events. The subset of uncontrollable events is denoted $\Sigma_u$. These are events which occur spontaneously within the corresponding time interval, and whose occurrence may not be disabled through control. The subset of controllable events is denoted $\Sigma_c$. These are events which may be preempted indefinitely from occurring through control, i.e. their occurrence may be disabled through control. Their upper time bounds is therefore always infinity. If not disabled, controllable events will occur within the corresponding time interval. The subset of forcible events is denoted $\Sigma_f$. Forcible events may either be uncontrollable or controllable. These are events that may be forced to occur through control any time during the corresponding time interval. Figure 1 illustrates the relation between $\Sigma$, $\Sigma_u$, $\Sigma_c$, and $\Sigma_f$.

**3 Composition**

In order to model the timed behavior of a number of timed based processes working in parallel, composition is required and is now presented.

Given a number of automata $A_i = (\Sigma_i, A_i, \delta_{A_i}, a_{o,i}, A_{m,i})$, $i = 1,..., n$ representing the untimed behavior of corresponding timed state based processes, one single automaton $A = (\Sigma_A, A, \delta_A, a_o, A_m)$ embodying the synchronized untimed behavior of the automata $A_i$, $i = 1,...,n$ is obtained as follows:

$$\Sigma_A = \bigcup_{i=1,...,n} \Sigma_i,$$

$$A = \prod_{i=1,...,n} A_i,$$

$$a_o = (a_{o,1},..., a_{o,n}),$$

$$A_m = \prod_{i=1,...,n} A_{m,i},$$

and
where $\delta_A : A \times \Sigma_A \to A$ is now defined. Let $\sigma \in \Sigma_A$. Write $\delta_A(a, \sigma) = a'$ with

$$a = (a_1, ..., a_n),$$

$$a' = (a'_1, ..., a'_n).$$

Then $\delta_A(a, \sigma)$ is defined if and only if for $i = 1, ..., n$ either $\delta_{A_i}(a_i, \sigma)$ is defined or $\sigma$ is not in $\Sigma_i$:

$$\delta_A(a, \sigma)! \text{ if and only if } (\delta_{A_i}(a_i, \sigma)! \vee \sigma \notin \Sigma_i), i = 1, ..., n.$$

The activity $a' = (a'_1, ..., a'_n)$ is then given by: for $i = 1, ..., n$

$$a'_i = \begin{cases} \delta_{A_i}(a_i, \sigma) & \text{if } \delta_{A_i}(a_i, \sigma)! \\ a_i & \text{otherwise.} \end{cases}$$

For further reference we will denote the synchronous composition of $A_i$, $i = 1,..., n$ into A, by $A = (\Sigma_A, A, \delta_A, a_o, A_m) = composition (A_1, ..., A_n)$.

Having composed the various $A_i$, $i = 1,..., n$ into A, and given the default lower and upper time bounds of the events $\sigma \in \Sigma_A$, the timed behavior E is obtained as described above in Section 2 above.

Note: It is assumed that any event $\sigma \in \Sigma_A$ has unique default lower and upper time bounds ($l_\sigma$, $u_\sigma$), even if $\sigma$ is shared by two or more alphabets $\Sigma_i$, $i \in \{1, ..., n\}$.

**4 Model construction algorithm**

While Sections 2 and 3 define the timed behavior E of given timed state based processes modeled by a number of automata $A_i$, $i$ 1,..., $n$ and the corresponding event default lower and upper time bounds, the present Section provides the algorithm to construct E from $A_i$, $i = 1,..., n$ and the corresponding event default lower and upper time bounds.

(1) Initialisation.
For further reference we define four sets (i) the *new set*, (ii) the *final set*, (iii) the *marker set*, and (iv) the *transitions set*, all of which are assumed initially empty.
We consider the initial timed activity

$$e_o = (a_o, \{(l_\sigma, u_\sigma) \text{ such that } \sigma \in \Sigma\}) \text{ with } a_o = (a_{o,1}, ..., a_{o,n})$$

Let

$$e = (a, \{(r_\sigma, t_\sigma) \text{ such that } \sigma \in \Sigma\}) \text{ with } a = (a_1, ..., a_n).$$

$$= e_o.$$

We add $e$ to the new set. Furthermore, if all the activities $a_i$, $i = 1, ..., n$ composing $a$ are marker activities, i.e. $a_i \in A_{m,i}$, $i = 1, ..., n$, we add $e$ to the marker set.

(2) Timed activities construction.
Let $e = (a, \{(r_\sigma, t_\sigma) \text{ such that } \sigma \in \Sigma\})$ *with* $a = (a_1, ..., a_n)$.
$e$ is removed from the new set and is placed in the final set.
For all the events $\sigma \in \Sigma$ such that $\delta_E(e,\sigma)$ is defined we compute the corresponding timed activity $\delta(e, \sigma) = e'$ reached from $e$ by $\sigma$.
Recall that $\delta_E(e, \sigma)$ is defined if and only if (i) $\delta_A(a, \sigma)$ is defined, and (ii) there does not exist an other event $\alpha \in \Sigma$ such that $\delta_A(a, \alpha)$ is defined and whose upper time bound $t_\alpha$ is strictly smaller than the lower time bound $r_\sigma$ of $\sigma$.
Let $e' = (a', \{(r'_\tau, t'_\tau) \text{ such that } \tau \in \Sigma\})$ with $a' = (a'_1, ..., a'_n)$.
$a'$ is computed as follows: for $i = 1, ..., n$

$$a'_i = \begin{cases} \delta_{A_i}(a_i, \sigma) & \text{if } \delta_{A_i}(a_i, \sigma)! \\ a_i & \text{otherwise.} \end{cases}$$

The lower and upper time bounds $(r'_\tau, t'_\tau)$, $\tau \in \Sigma$ are computed as follows:

if $\tau \neq \sigma$

$$(r'_\tau, t'_\tau) = \begin{cases} (r_\tau \dot{-} t_\sigma, t_\tau \dot{-} r_\sigma) & \text{if } \delta_A(a, \tau)! \wedge \delta_A(a', \tau)! \\ (l_\tau, u_\tau) & \text{otherwise} \end{cases}$$

if $\tau = \sigma$

$$(r'_\tau, t'_\tau) = (l_\tau, u_\tau).$$

Then, (i) if $e'$ is not in the final set, we add $e'$ to the new set, and if all the activities $a'_i$, $i = 1, ..., n$ composing $a'$ are marker activities, i.e. $a'_i \in A_{m,i}$, $i = 1, ..., n$, we add $e'$ to the marker set; (ii) the transition $(e, \sigma, e')$ is added to the transitions set.

(3) Timed activities construction loop.
We consider in turn all the timed activities in the new set and repeat steps (2) to (3) until the new set is empty.

Then, for the automaton $\mathbf{E} = (\Sigma, E, \delta_E, e_o, E_m)$ we have $\Sigma$ given as above, and

| | |
|---|---|
| $E =$ | final set |
| $\delta_E =$ | transitions set |
| $e_o =$ | $(a_o, \{(l_\sigma, u_\sigma)$ such that $\sigma \in \Sigma\})$ with $a_o = (a_{o,1}, ..., a_{o,n})$ |
| $E_m =$ | marker set . |

**Modeling example 1: Traffic system**

The timed behavior of two vehicles crossing an intersection is modeled below. The two vehicles $V_1$, $V_2$ are shown in Figure 2. We are given for Vehicle1:

$$A_1 = (\Sigma_1, A_1, \delta_{A_1}, a_{o,1}, A_{m,1})$$

| | |
|---|---|
| $A_1 =$ | $\{departing_1, crossed_1\}$ |
| $\delta_{A_1} =$ | $\{(departure_1, pass_1, crossed_1)\}$ |
| $a_{o,1} =$ | $departing_1$ |
| $A_{m,1} =$ | $\{crossed_1\}$ |

together with the following default lower and upper time bounds $(l_{pass_1}, u_{pass_1}) = (8,10)$. We are given for Vehicle2:

$$A_2 = (\Sigma_2, A_2, \delta_{A_2}, a_{o,2}, A_{m,2})$$

| | |
|---|---|
| $A_2 =$ | $\{departing_2, crossed_2\}$ |
| $\delta_{A_2} =$ | $\{(departure_2, pass_2, crossed_2)\}$ |
| $a_{o,2} =$ | $departing_2$ |
| $A_{m,2} =$ | $\{crossed_2\}$ |

together with the following default lower and upper time bounds $(l_{pass2}, u_{pass2}) = (5, \infty)$.

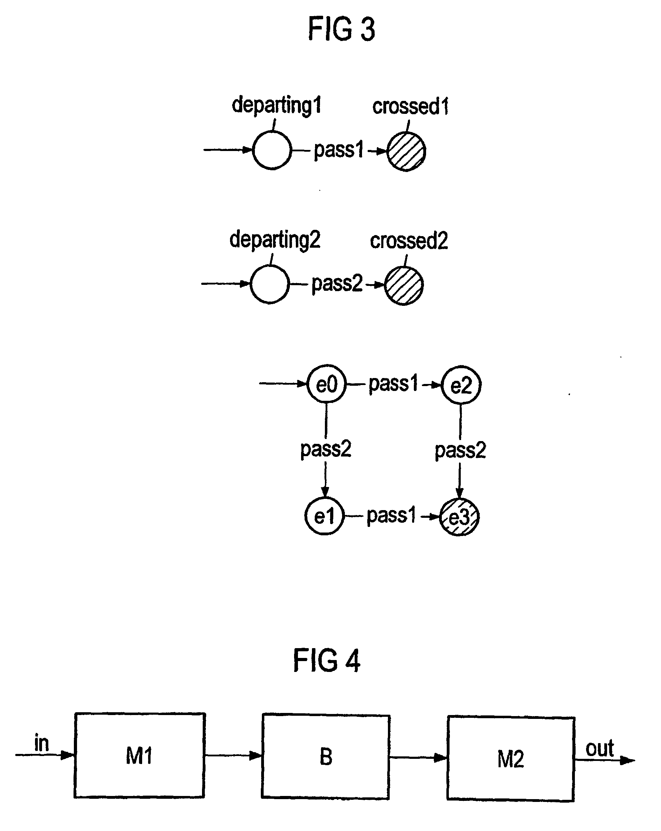

The corresponding timed behavior $\mathbf{E}$ of the two vehicles traveling concurrently is obtained according to the procedure presented in Section 4, and is shown in Figure 3.

$$E = (\Sigma, E, \delta_E, e_o, E_m)$$

| | |
|---|---|
| $\Sigma =$ | $\{pass_1, pass_2\}$ |
| $E =$ | $\{e_o, e_1, e_2, e_3\}$ where |

| | |
|---|---|
| $e_o =$ | $((departing_1, departing_2), (8, 10)(5, \infty))$ |
| $e_1 =$ | $((departing_1, crossed_2), (0, 5)(5, \infty))$ |
| $e_2 =$ | $((crossed_1, departing_2), (8, 10)(0, \infty))$ |
| $e_3 =$ | $((crossed_1, crossed_2), (8, 10)(5, \infty))$ |

| | |
|---|---|
| $\delta_E =$ | $\{(e_o, pass_1, e_2), (e_o, pass_2, e_1), (e_1, pass_1, e_3), (e_2, pass_2, e_3)\}$ |
| $e_o =$ | $((departing_1, departing_2), (8, 10)(5, \infty))$ |
| $E_m =$ | $\{((crossed_1, crossed_2), (8, 10)(5, \infty))\}$ |

It is important to note that the present model has 4 timed activities and 4 transitions versus 19 states and 30 transition using the state of the art.

**Modeling example 2: A two-machine manufacturing cell**

The timed behavior of two machines constituting a manufacturing cell is modeled below. The cell is shown in Figure 4.We are given for Machine1:

$$A_1 = (\Sigma_1, A_1, \delta_{A_1}, a_{o,1}, A_{m,1})$$

$A_1 =$      $\{processing_1\}$
$\delta_{A_1} =$      $\{(operational_1, work_1, operational_1)\}$
$a_{o,1} =$      $operational_1$
$A_{m,1} =$      $\{operational_1\}$

together with the following default lower and upper time bounds $(l_{work_1}, u_{work_1}) = (5,5)$. We are given for Machine2:

$$A_2 = (\Sigma_2, A_2, \delta_{A_2}, a_{o,2}, A_{m,2})$$

$A_2 =$      $\{processing_2\}$
$\delta_{A_2} =$      $\{(operational_2, work_2, operational_2)\}$
$a_{o,2} =$      $operational_2$
$A_{m,2} =$      $\{operational_2\}$

together with the following default lower and upper time bounds $(l_{work2}, u_{work2}) = (2, \infty)$.

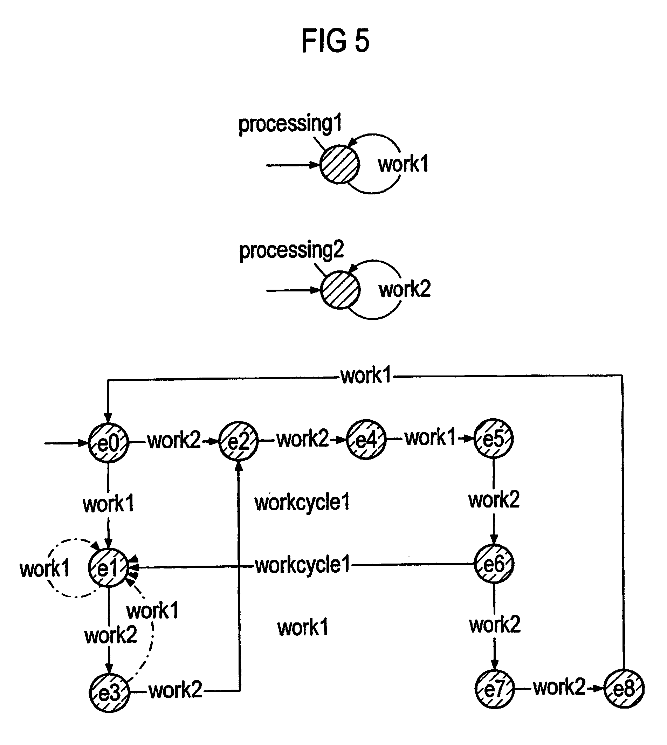

The corresponding timed behavior **E** of the two machines working concurrently is obtained according to the procedure presented in Section 4, and is shown in Figure 5.

$$E = (\Sigma, E, \delta_E, e_o, E_m)$$

where

$\Sigma =$      $\{work_1, work_2\}$
$E =$      $\{e_o, e_1, e_2, e_3, e_4, e_5, e_6, e_7, e_8\}$ where

     $e_o =$      $((operational_1, operational_2), (5, 5)(2, \infty))$
     $e_1 =$      $((operational_1, operational_2), (5,5)(0, \infty))$
     $e_2 =$      $((operational_1, operational_2), (0, 3)(2, \infty))$
     $e_3 =$      $((operational_1, operational_2), (0, 5) (2, \infty))$
     $e_4 =$      $((operational_1, operational_2), (0, 1)(2, \infty))$
     $e_5 =$      $((operational_1, operational_2), (5, 5)(1, \infty))$
     $e_6 =$      $((operational_1, operational_2), (0, 4) (2, \infty))$
     $e_7 =$      $((operational_1, operational_2), (0, 2)(2, \infty))$
     $e_8 =$      $((operational_1, operational_2), (0,0) (2, \infty))$

$\delta_E =$      $\{(e_o, work_1, e_1), (e_o, work_2, e_2),$
     $(e_1, work_2, e_3), (e_1, work_1, e_1),$
     $(e_2, work_1, e_4),$
     $(e_3, work_2, e_2), (e_3, work_1, e_1),$
     $(e_4, work_1, e_5),$
     $(e_5, work_2, e_6), (e_5, work_1, e_1),$
     $(e_6, work_2, e_7), (e_6, work_1, e_1),$
     $(e_7, work_2, e_8), (e_7, work_1, e_1),$
     $(e_8, work_1, e_o)\}$
$e_o =$      $((operational_1, operational_2), (5,5)(2,\infty)),$
$E_m =$      $E.$

Again, it is important to note that the present model has 9 timed activities and 15 transitions versus 18 states and 24 transition using the state of the art.

**5 Discussion**

The proposed approach to the modeling of timed state based processes offer important advantages over other approaches. These are now summarized below:

(i) very compact modeling in which the timing information on the occurrence of events is incorporated in the activities of the processes considered, and not explicitly in the form of *tick* transitions; this curbs the activity (state) explosion phenomenon encountered when large time bounds are considered in state of the art which use *ticks;*

(ii) very efficient model construction algorithm which does not require (a) the construction of all the submodels composing the timed state based processes considered, and (b) their subsequent composition into the final model: the construction approach thus curbs the activity (state) explosion phenomenon, by directly constructing the transition structures embodying the synchronous behavior of all component processes;

**Claims**

1. Method for modelling a process flow according to time constraints on a computer having following features:

a) at least a first and a second partial process of the process flow are described in fashion of a first and a second finite state machine and each one is respectively provided with an upper and a lower time bound measured in time units, whereas the lower time bound defines the earliest possible point in time and the upper time bound the latest point in time when the state transition may happen and the time units are counted as soon as a state of a finite state machine is reached from which the state transition is defined;
b) the modelling is started with at least one state transition, as initialtransition, which has the lowest lower time bound;
c) a first model state is being created, in furnishing all the possible state transitions which may start from this model state, the furtherstatetransitions, except the initialtransition, with new time bounds, in subtracting the upper time bound of the initialtransition from the former lower time bound of the respective state transition to build its new lower time bound and in subtracting the lower time bound of the initialtransition from the former upper time bound of the respective state transition to build its new upper time bound;
d) negative time values are being set to zero.

2. Method according to claim 1 having following features:

a) a further model state is being created, in proceeding with a furtherstatetransition and in furnishing all the possible state transitions which may start from this model state, except the furtherstatetransition, with new time bounds, in subtracting the upper time bound of the furtherstatetransition from the former lower time bound of the respective state transition to build its new lower time bound and in subtracting the lower time bound of the initialtransition from the former upper time bound of the respective state transition to build its new upper time bound;
b) feature a) is being carried out for all furtherstatetransitions, until starting from the respective model state and if necessary step by step continuing over other model states in doing furtherstatetransitions, each furtherstatetransitions has had to take place by force because of its lower time bound or a model state is reached which has been already analysed.

3. Method according to one of the preceding claims,

a) where in a first initialisation step four sets, the new set, the final set, the marker set, and the transitions set, all of which are initially empty are defined, with the initial timed activity

$$e_0 = \left(a_0, \left\{(l_\sigma, u_\sigma) \text{ such that } \sigma \in \Sigma\right\}\right) \text{ with } a_0 = (a_{0,1}, \ldots, a_{0,n})$$

and with

$$e = e_0 = \left(a, \left\{(r_\sigma, t_\sigma) \text{ such that } \sigma \in \Sigma\right\}\right) \quad \text{with } a = (a_1, \ldots, a_n)$$

and where e is added to the new set and, if all the activities $a_i$, i = 1,...,n composing a are marker activities, i. e. $a_i \in A_{m,i}$, i = 1,...,n, e is added to the marker set,
b) where for

$$e = e_0 = \left(a, \left\{(r_\sigma, t_\sigma) \text{ such that } \sigma \in \Sigma\right\}\right) \qquad \text{with } a = (a_1, \ldots, a_n)$$

e is removed from the new set and is placed in the final set,
c) where for all the events $\sigma \in \Sigma$ such that $\delta_A(a,\sigma)$ is defined the corresponding timed activity $e'=\delta_A(a,\sigma)$ reached from e by $\sigma$ is computed with

$$e' = \left(a', \left\{(r'_\tau, t'_\tau) \text{ such that } \tau \in \Sigma\right\}\right) \quad \text{with } a' = (a_1', \ldots, a_n')$$

a' is computed for i = 1,...,n as follows:

$$a_i' = \begin{cases} \delta_{A_i}(a_i, \sigma) \text{ if } \delta_{A_i}(a_i, \sigma)! \\ \quad a_i \text{ otherwise} \end{cases}$$

and for $\tau \neq \sigma$ the lower and upper time bounds $(r'_\tau, t'_\tau)$, $r \in \Sigma$ are computed as follows:

$$(r'_\tau, t'_\tau) = \begin{cases} (r_\tau - t_\sigma, t_\tau - r_\sigma) \text{ if } \delta_{A_i}(a,r)! \wedge \delta_{A_i}(a',r)! \\ \quad (l_r, u_r) \text{ otherwise} \end{cases}$$

and for $\tau = \sigma$ are computed as

$$(r'_\tau, t'_\tau) = (l_r, u_r)$$

and, if e' is not in the final set, it is added to the new set, and if all the activities $a'_i$ $A_{m,i}$, i = 1,...,n, are marker activities e' is added to the marker set; and the furtherstatetransition (e,$\sigma$,e') is added to the transitions set,
d) and where steps b) and c) are repeated until the new set is empty.

4. Method according to claim 3,
where a graphical output is generated in placing all the elements in the transitions set together with the corresponding model states on a display.

5. Method according to claim 4,
where the appropriate connections between the model states are deduced from the transitions set and established correspondingly.

**Revendications**

1. Méthode pour modéliser un déroulement de processus selon des contraintes de temps sur un ordinateur ayant les caractéristiques suivantes :

a) au moins un premier et un deuxième processus partiel du déroulement de processus sont décrits à la façon d'une première et d'une deuxième machine à états finis et chacun est doté respectivement d'une limite de temps supérieure et inférieure mesurées en unités de temps, alors que la limite de temps inférieure définit le point le plus précoce possible dans le temps, et la limite de temps supérieure le point le plus tardif dans le temps quand la transition d'état peut survenir et les unités de temps sont comptées dès qu'un état d'une machine à états finis est atteint à partir duquel la transition d'état est définie ;

b) la modélisation est lancée avec au moins une transition d'état, comme *transition initiale,* qui a la limite de temps inférieure la plus basse ;

c) un premier état de modèle est créé, en fournissant toutes les transitions d'état possibles qui peuvent démarrer de cet état de modèle, les *transitions d'état ultérieures,* à l'exception des *transitions initiales,* avec de nouvelles limites de temps, en soustrayant la limite de temps supérieure de la *transition initiale* de la limite de temps inférieure de la transition d'état respective pour construire sa nouvelle limite de temps inférieure et en soustrayant la limite de temps inférieure de la *transition initiale* de la limite de temps supérieure précédente de la transition d'état respective pour construire sa nouvelle limite de temps supérieure;

d) les valeurs de temps négatives sont mises à zéro.

**2.** Méthode selon la revendication 1, ayant les caractéristiques suivantes :

a) un autre état de modèle est créé, en poursuivant avec une *transition d'état ultérieure* et en fournissant toutes les transitions d'état possibles qui peuvent démarrer de cet état de modèle, à l'exception des *transitions d'état ultérieures,* avec de nouvelles limites de temps, en soustrayant la limite de temps supérieure de la *transition d'état ultérieure* de la limite de temps inférieure précédente de la transition d'état respective pour construire sa nouvelle limite de temps inférieure et en soustrayant la limite de temps inférieure de la *transition initiale* de la limite de temps supérieure précédente de la transition d'état respective pour construire sa nouvelle limite de temps supérieure ;

b) la caractéristique a) étant exécutée pour toutes les *transitions d'état ultérieures,* jusqu'au démarrage à partir de l'état de modèle respectif et si nécessaire pas-à-pas en poursuivant sur d'autres états de modèle en faisant des *transitions d'état ultérieures,* chaque *transition d'état ultérieure* ayant été exécutée sous contrainte du fait que leur limite de temps inférieure ou un état de modèle est atteint qui a déjà été analysé.

**3.** Méthode selon l'une quelconque des revendications précédentes,

a) dans laquelle, dans une première étape d'initialisation, quatre ensembles : le nouvel ensemble, l'ensemble final, l'ensemble de marqueurs et l'ensemble de transitions, dont tous sont vides à l'origine, sont définis, avec l'activité programmée initiale

$$e_0 = (a_0, \{(l_\sigma, u_\sigma) \text{ tel que } \sigma \in \Sigma\}) \text{ avec } a_0 = (a_{0,1}, ..., a_{0,n})$$

et avec

$$e = e_0 = (a, \{(r_\sigma, t_\sigma) \text{ tel que } \sigma \in \Sigma\}) \text{ avec } a = \{a_1, ..., a_n\}$$

et où $e$ est ajouté au nouvel ensemble et, si toutes les activités $a_i$, $i = 1, ..., n$ constituant $a$ sont des activités de marqueurs, c'est-à-dire $a_i \in A_{m,i}$, $i = 1, ..., n$, $e$ est ajouté à l'ensemble de marqueurs,

b) dans laquelle, pour

$$e = e_0 = (a, \{(r_\sigma, t_\sigma) \text{ tel que } \sigma \in \Sigma\}) \text{ avec } a = (a_1, ..., a_n)$$

$e$ est supprimé du nouvel ensemble et est placé dans l'ensemble final,

c) dans laquelle, pour tous les événements $\sigma \in \Sigma$ tels que $\delta_A (a, \sigma)$ soit défini, l'activité programmée correspondante e' = $\delta_A (a, \sigma)$ atteinte de $e$ par $\sigma$ est calculée avec

$$e' = (a', \{(r'_\tau, t'_\tau) \text{ tel que } \tau \in \Sigma\}) \text{ avec } a' = (a'_1, ..., a'_n)$$

$a'$ est calculé pour i = 1, ..., $n$ comme suit :

$$a'_i = \begin{cases} \dfrac{\delta_{A_i}(a_i,\sigma) \quad si\ \delta_{A_i}(a_i,\sigma)\ !}{a_i \qquad\qquad autrement} \end{cases}$$

et pour $\tau \neq \sigma$, les limites de temps supérieures et inférieures $(r'_\tau, t'_\tau)$, $\tau \in \Sigma$ sont calculées comme suit :

$$(r'_\tau, t'_\tau) = \begin{cases} [r_\tau - t_\sigma, t_\tau - r_\sigma]\, si\delta_{A_i}(a,\tau)! \wedge \delta_{A_i}(a',\tau)! \\ (l_\tau, u_\tau)\ autrement \end{cases}$$

et pour $\tau = \sigma$ sont calculés comme suit :

$$(r'_\tau, t'_\tau) = (l_\tau, u_\tau).$$

et, si $e'$ n'est pas l'ensemble final, il est ajouté au nouvel ensemble, et si toutes les activités $a'_i$, $A_{m,i}$, $i = 1,...,$ $n$, sont des activités de marqueurs, $e'$ est ajouté à l'ensemble de marqueurs ; et la *transition d'état ultérieure* *(e,* $\sigma$, *e')* est ajoutée à l'ensemble de transitions,
d) et dans laquelle les étapes b) et c) sont répétées jusqu'à ce que le nouvel ensemble soit vide.

**4.** Méthode selon la revendication 3, dans laquelle une sortie graphique est générée en plaçant tous les éléments dans l'ensemble de transitions conjointement avec les états de modèle correspondants sur un écran d'affichage.

**5.** Méthode selon la revendication 4, dans laquelle les connexions appropriées entre les états de modèle sont déduites de l'ensemble de transitions et établies en conséquence.

**Patentansprüche**

**1.** Verfahren zur Modellierung eines Prozeßflusses gemäß zeitlichen Nebenbedingungen auf einem Computer mit den folgenden Merkmalen:

a) mindestens ein erster und ein zweiter teilweiser Prozeß des Prozeßflusses werden in Art eines ersten und eines zweiten Automaten beschrieben, und jeder wird jeweils mit einer in Zeiteinheiten gemessenen oberen und unteren Zeitschranke versehen, wohingegen die untere Zeitschranke den frühestmöglichen Zeitpunkt und die obere Zeitschranke den spätesten Zeitpunkt definiert, an dem der Zustandsübergang stattfinden kann, und die Zeiteinheiten gezählt werden, sobald ein Zustand eines Automaten erreicht ist, von wo aus der Zustandsübergang definiert wird;

b) das Modellieren wird mit mindestens einem Zustandsübergang als initialtransition gestartet, der die niedrigste Zeitschranke aufweist;

c) ein erster Modellzustand wird erzeugt, durch Bereitstellung aller möglichen Zustandsübergänge, die von diesem Modellzustand aus starten können, der furtherstatetransitions, mit Ausnahme des initialtransition, mit neuen Zeitschranken, durch Subtraktion der oberen Zeitschranke des initialtransition von der ehemaligen unteren Zeitschranke des jeweiligen Zustandsübergangs, um dessen neue untere Zeitschranke aufzubauen, und durch Subtraktion der unteren Zeitschranke des initialtransition von der ehemaligen oberen Zeitschranke des jeweiligen Zustandsübergangs, um dessen neue obere Zeitschranke aufzubauen;

d) negative Zeitwerte werden auf Null gesetzt.

**2.** Verfahren nach Anspruch 1 mit den folgenden Merkmalen:

a) ein weiterer Modellzustand wird erzeugt, durch Voranschreiten mit einem furtherstatetransition und durch Bereitstellung aller möglichen Zustandsübergänge, die von diesem Modellzustand aus starten können, mit Ausnahme des furtherstatetransition, mit neuen Zeitschranken, durch Subtraktion der oberen Zeitschranke des furtherstatetransition von der ehemaligen unteren Zeitschranke des jeweiligen Zustandsübergangs, um dessen neue untere Zeitschranke aufzubauen, und durch Subtraktion der unteren Zeitschranke des initialtransition von der ehemaligen oberen Zeitschranke des jeweiligen Zustandsübergangs, um dessen neue obere Zeitschranke aufzubauen;

b) Merkmal a) wird für alle furtherstatetransitions ausgeführt, bis zum Starten von dem jeweiligen Modellzustand, und wobei falls notwendig schrittweise über andere Modellzustände bei der Durchführung von furtherstatetransitions fortgefahren wird, wobei jedes furtherstatetransitions durch Zwang stattgefunden haben muß, weil seine untere Zeitschranke oder ein Modellzustand erreicht wird, der bereits untersucht wurde.

3.  Verfahren nach einem der vorhergehenden Ansprüche,

a) wobei in einem ersten Initialisierungsschritt vier Mengen, die neue Menge, die letzte Menge, die Markierermenge und die Übergangsmenge, die alle, anfangs leer, mit der folgenden anfänglichen zeitgesteuerten Aktivität definiert werden:

$$e_0 = \Big(a_0, \big\{(l_\sigma, u_\sigma) \text{ für alle } \sigma \in \Sigma\big\}\Big),$$
$$\text{mit } a_0 = (a_{0,1}, \ldots, a_{0,n})$$

und mit

$$e = e_0 = \Big(a, \big\{(r_\sigma, t_\sigma) \text{ für alle } \sigma \in \Sigma\big\}\Big),$$
$$\text{mit } a = (a_1, \ldots, a_n)$$

und wobei e zu der neuen Menge hinzugefügt wird, und wenn alle Aktivitäten $a_i$, i = 1, ..., n, aus denen a besteht, Markiereraktivitäten sind, d.h. $a_i \in A_{m,i}$, i = 1, ..., n, gilt, e zu der Markierermenge hinzugefügt wird,

b) wobei für

$$e = e_0 = \Big(a, \big\{(r_\sigma, t_\sigma) \text{ für alle } \sigma \in \Sigma\big\}\Big),$$
$$\text{mit } a = (a_1, \ldots, a_n)$$

e aus der neuen Menge entfernt und in die letzte Menge gebracht wird,

c) wobei für alle Ereignisse $\sigma \in \Sigma$, für die $\delta_A(a, \sigma)$ definiert ist, die entsprechende zeitgesteuerte Aktivität e' = $\delta_A(a, \sigma)$, die von e aus durch $\sigma$ erreicht wird, folgendermaßen berechnet wird:

$$e' = \Big(a', \big\{(r'_\tau, t'_\tau) \text{ für alle } \tau \in \Sigma\big\}\Big),$$
$$\text{mit } a' = (a'_1, \ldots, a'_n)$$

a' für i = 1, ..., n folgendermaßen berechnet wird:

$$a_i' = \begin{cases} \delta_{A_i}(a_i, \sigma) & \text{für } \delta_{A_i}(a_i, \sigma)! \\ a_i & \text{andernfalls} \end{cases}$$

und für $\tau \neq \sigma$ die untere und die obere Zeitschranke $(r'_\tau, t'_\tau)$, $r \in \Sigma$, folgendermaßen berechnet werden:

$$(r_\tau', t_\tau') = \begin{cases} (r_\tau - t_\sigma, t_\tau - r_\sigma) & \text{für } \delta_{A_i}(a, r)! \wedge \delta_{A_i}(a', r)! \\ (l_r, u_r) & \text{andernfalls} \end{cases}$$

und für $\tau = \sigma$ folgendermaßen berechnet werden:

$$(r'_\tau, t'_\tau) = (l_r, u_r)$$

und wenn sich e' nicht in der letzten Menge befindet, es zu der neuen Menge hinzugefügt wird, und wenn alle Aktivitäten $a'_i$, $A_{m,i}$, i = 1, ..., n, Markiereraktivitäten sind, e' zu der Markierermenge hinzugefügt wird; und das furtherstatetransition (e, $\sigma$, e') zu der Übergangsmenge hinzugefügt wird,

d) wobei die Schritte b) und c) wiederholt werden, bis die neue Menge leer ist.

4. Verfahren nach Anspruch 3, wobei eine graphische Ausgabe erzeugt wird, durch Plazieren aller Elemente in der Übergangsmenge zusammen mit den entsprechenden Modellzuständen auf einer Anzeige.

5. Verfahren nach Anspruch 4, wobei die entsprechenden Verbindungen zwischen den Modellzuständen aus der Übergangsmenge deduziert und entsprechend etabliert werden.

# FIG 1

$\Sigma u$

$\Sigma c$

$\Sigma$

$\Sigma f$

# FIG 2

crossed2

V1

crossed1

crossed1

V2

departing2

# FIG 3

# FIG 4

# FIG 5